(19) Europäisches Patentamt
European Patent Office
Office européen des brevets

(11) **EP 4 708 704 A1**

(12) **EUROPEAN PATENT APPLICATION**
published in accordance with Art. 153(4) EPC

(43) Date of publication:
**11.03.2026 Bulletin 2026/11**

(21) Application number: **24818260.2**

(22) Date of filing: **05.02.2024**

(51) International Patent Classification (IPC):
**H03M 13/37** (2006.01)      **G06F 11/10** (2006.01)
**G06F 3/06** (2006.01)

(52) Cooperative Patent Classification (CPC):
**G06F 3/06; G06F 11/10; H03M 13/37**

(86) International application number:
**PCT/CN2024/076006**

(87) International publication number:
**WO 2024/250722 (12.12.2024 Gazette 2024/50)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **07.06.2023 CN 202310672401**

(71) Applicant: **ZTE Corporation
Shenzhen, Guangdong 518057 (CN)**

(72) Inventors:
• **ZHAO, Wei**
  **Shenzhen, Guangdong 518057 (CN)**
• **LI, Liguang**
  **Shenzhen, Guangdong 518057 (CN)**
• **XU, Jin**
  **Shenzhen, Guangdong 518057 (CN)**
• **LIANG, Chulong**
  **Shenzhen, Guangdong 518057 (CN)**

(74) Representative: **Ziebig Hengelhaupt Intellectual
Property Attorneys
Patentanwaltskanzlei PartGmbB
Leipziger Straße 49
10117 Berlin (DE)**

(54) **DATA PROCESSING METHOD, APPARATUS AND STORAGE MEDIUM**

(57)      The embodiments of the present application relate to the technical field of communications. Provided are a data processing method, an apparatus and a storage medium, which are used for ensuring the reliability of data storage and reducing the computing resource overheads. The method comprises: acquiring k source data blocks, wherein k is a positive integer; and encoding the k source data blocks according to a first generation matrix to obtain n first encoded data blocks, wherein the value range of elements in the first generation matrix is [0, q-1], and q is a prime number or the power of the prime number.

```
┌─────────────────────────────────────┐   S101
│                                     │
│      Acquire k source data blocks   │
│                                     │
└─────────────────────────────────────┘
                   │
                   ▼
┌─────────────────────────────────────┐   S102
│   Encode the k source data blocks   │
│  according to a first generation    │
│  matrix to obtain n first encoded   │
│         data blocks                 │
└─────────────────────────────────────┘
```

FIG. 3

EP 4 708 704 A1

## Description

The present disclosure claims priority to the Chinese Patent Application with application No. 202310672401.0, filed on June 7, 2023. The entire content of the Chinese Patent Application is incorporated by reference in the present application.

<u>TECHNICAL FIELD</u>

The present disclosure relates to the field of communication technologies, and in particular, to a data processing method, an apparatus, and a storage medium.

<u>BACKGROUND</u>

With the rapid development of information technologies, the data volume that needs to be stored shows explosive growth, and how to store and acquire data that needs to be stored safely, reliably, and efficiently is a problem that needs to be considered. In a data storage system, redundancy is usually increased to ensure data reliability and durability, and currently, commonly used technologies include: multi-copy technology and erasure coding technology. However, the storage space utilization of multi-copy technology is low, which will lead to a multiplicative increase in storage costs for massive data storage in the future. Compared to multi-copy technology, erasure coding technology can achieve higher data reliability with smaller redundancy. However, the encoding and decoding of erasure coding technology are relatively complex, involving multiplication operations in a finite field, and therefore require more computational resources. Therefore, how to ensure data storage reliability and reduce computing resource overhead is a technical problem that needs to be solved urgently.

<u>SUMMARY</u>

The present disclosure provides a data processing method, an apparatus, and a storage medium, which are used to ensure data storage reliability and reduce computing resource overhead.
To achieve the aforementioned objective, the present disclosure adopts the following technical solution.
In a first aspect, there is provided a data processing method. The method is applied to a first processing node. The method includes:

acquiring k source data blocks, where k is a positive integer;
encoding the k source data blocks according to a first generator matrix to obtain n first encoded data blocks, where a value range of an element of the first generator matrix is [0, q-1], and q is a prime number or a prime power.

In a second aspect, there is provided a data processing method. The method is applied to a second processing node. The method includes:

acquiring a type and a quantity of faulty first encoded data blocks, and acquiring k non-faulty first encoded data blocks generated by a first processing node; where the k non-faulty first encoded data blocks are a subset of n first encoded data blocks obtained by the first processing node encoding k source data blocks according to a first generator matrix; the first generator matrix includes an identity matrix and a second generator matrix, a size of the identity matrix is k×k, a size of the second generator matrix is r×k, and n = r + k, where r is a positive integer;
processing the k non-faulty first encoded data blocks according to the type and the quantity of the faulty first encoded data blocks to obtain data of the faulty first encoded data blocks; where the type of the faulty first encoded data blocks includes a source data block or a second encoded data block, the second encoded data block is a data block obtained by encoding the k source data blocks according to a second generator matrix, the quantity of the faulty first encoded data blocks is an integer greater than or equal to 0 and less than or equal to n, and the data of the faulty first encoded data blocks includes a faulty source data block and a faulty second encoded data block.

In a third aspect, there is provided a communication apparatus. The apparatus includes:

an acquisition unit, configured to acquire k source data blocks, where k is a positive integer;
a processing unit, configured to encode the k source data blocks according to a first generator matrix to obtain n first encoded data blocks, where a value range of an element of the first generator matrix is [0, q-1], and q is a prime number or a prime power.

In a fourth aspect, there is provided a communication apparatus. The apparatus includes:

an acquisition unit, configured to acquire a type and a quantity of faulty first encoded data blocks, and acquire k non-faulty first encoded data blocks generated by a first processing node; where the k non-faulty first encoded data blocks are a subset of n first encoded data blocks obtained by the first processing node encoding k source data blocks according to a first generator matrix; the first generator matrix includes an identity matrix and a second generator matrix, a size of the identity matrix is $k \times k$, a size of the second generator matrix is $r \times k$, and $n = r + k$, where r is a positive integer;

a processing unit, configured to process the k non-faulty first encoded data blocks according to the type and the quantity of the faulty first encoded data blocks to obtain data of the faulty first encoded data blocks; where the type of the faulty first encoded data blocks includes a source data block or a second encoded data block, the second encoded data block is a data block obtained by encoding the k source data blocks according to a second generator matrix, the quantity of the faulty first encoded data blocks is an integer greater than or equal to 0 and less than or equal to n, and the data of the faulty first encoded data blocks includes a faulty source data block and a faulty second encoded data block.

In a fifth aspect, there is provided a communication apparatus, including: a processor and a memory; the memory stores instructions executable by the processor; the processor is configured to, upon executing the instructions, enable the communication apparatus to implement the method provided in any one of the first aspect or the second aspect described above.

In a sixth aspect, there is provided a computer-readable storage medium. The computer-readable storage medium stores computer instructions, where the computer instructions, upon being run on a computer, enable the computer to execute the method provided in any one of the first aspect or the second aspect.

In a seventh aspect, there is provided a computer program product containing computer instructions, where the computer instructions, upon being run on a computer, enable the computer to execute the method provided in any one of the first aspect or the second aspect.

In the embodiments of the present disclosure, since the n first encoded data blocks are obtained by the first processing node encoding the k source data blocks according to a first generator matrix, so that the encoding computation amount may be reduced without reducing storage reliability, thereby ensuring data storage reliability and reducing computing resource overhead. In a process of data recovery at a second node, since failures of storage nodes in a storage system are mostly single storage node failures, so that when a first encoded data block of a single storage node fails, based on this, the k non-faulty first encoded data blocks are processed to finally obtain data of the faulty first encoded data blocks according to the type and the quantity of the faulty first encoded data blocks. Since there is a target row being all 1 in the second generator matrix, and the k non-faulty first encoded data blocks are a subset of n first encoded data blocks obtained by the first processing node encoding the k source data blocks according to a first generator matrix, when the k non-faulty first encoded data blocks include a third encoded data block, so that when a single source data block fails, the faulty source data block may be obtained through an XOR operation, further reducing the computation amount, thereby ensuring data storage reliability and reducing computing resource overhead.

BRIEF DESCRIPTION OF THE DRAWINGS

The drawings are used to provide further understanding of the technical solution of the present disclosure, and constitute a part of the specification. The drawings are used to explain the technical solution of the present disclosure together with the embodiments of the present disclosure, and do not constitute a limitation to the technical solution of the present disclosure.

FIG. 1 is a structural schematic diagram of a communication system provided by the embodiments of the present disclosure.

FIG. 2 is a composition schematic diagram of a storage node set provided by the embodiments of the present disclosure.

FIG. 3 is a flow schematic diagram of a data processing method provided by the embodiments of the present disclosure.

FIG. 4 is a composition schematic diagram of a first generator matrix provided by the embodiments of the present disclosure.

FIG. 5 is a flow schematic diagram of another data processing method provided by the embodiments of the present disclosure.

FIG. 6 is a flow schematic diagram of another data processing method provided by the embodiments of the present disclosure.

FIG. 7 is a composition schematic diagram of a communication apparatus provided by the embodiments of the present disclosure.

FIG. 8 is a composition schematic diagram of another communication apparatus provided by the embodiments of the present disclosure.

FIG. 9 is a structural schematic diagram of a communication apparatus provided by the embodiments of the present disclosure.

DETAILED DESCRIPTION

The technical solutions in the embodiments of the present disclosure are clearly and completely described with reference to the accompanying drawings in the embodiments of the present disclosure below. Obviously, the described embodiments are only a part of the embodiments of the present disclosure, and not all embodiments. Based on the embodiments in the present disclosure, all other embodiments obtained by ordinary technicians in this field without creative work belong to the scope of protection of the present disclosure.

The terms "first" and "second" are used only for descriptive purposes, and cannot be understood as indicating or implying relative importance or implicitly specifying the quantity of the indicated technical features. Thus, features defined with "first" and "second" may explicitly or implicitly include one or more of such features. In the description of the present disclosure, unless otherwise specified, the meaning of "multiple/plurality of" is two or more.

In the embodiments of the present disclosure, words such as "exemplary" or "for example" are used to represent that the defined subjects are as examples, illustrations, or explanations. Any embodiment or design solution described as "exemplary" or "for example" in the embodiments of the present disclosure should not be interpreted as more preferred or more advantageous than other embodiments or design solutions. Precisely, the usage of words such as "exemplary" or "for example" aims to present related concepts in a specific manner.

In a data storage system, redundancy is usually increased to ensure data reliability and durability, and currently, commonly used technologies include: multi-copy technology and erasure coding technology. Multi-copy technology refers to copying the same data into n copies of data, and then distributing and storing the n copies of data in different nodes according to a certain strategy. The nodes include but are not limited to disks, solid state drives, servers, and other devices with storage functions. These nodes are independent. When at most n-1 nodes fail, causing the data stored in them to fail, and the same data as in the failed nodes can still be acquired from non-failed nodes, thereby providing data protection. The advantage of using multi-copy technology is that complex operations are not required, the operation is simple, and since there are no complex multiplication operations, the data read/write speed is fast. However, the storage space utilization of multi-copy technology is low, which will lead to a multiplicative increase in storage costs for massive data storage in the future. Therefore, multi-copy technology is usually used in hot data.

Erasure coding technology is a forward error correction technology, mainly applied in network transmission to avoid data packet loss. In storage systems, erasure coding technology is usually used to improve storage reliability. Compared to multi-copy technology, erasure coding technology can achieve higher data reliability with smaller redundancy. However, the encoding and decoding of erasure coding technology are relatively complex, involving multiplication operations in a finite field, and therefore require more computational resources. In a storage system, erasure coding technology is generally applied in warm data or cold data. The most widely used erasure code in storage systems is the Reed-Solomon (RS) erasure code, which is a systematic code. The check data is usually obtained through finite field operations between the source data and a Vandermonde Matrix or a Cauchy Matrix, herein referred to as Cauchy RS and Vandermonde RS, respectively. However, in a finite field (e.g., GF(256)), Vandermonde RS has the problem of decoding failure under certain redundancy ratios, and Cauchy RS does not have the problem of decoding failure, but when the finite field is large, the decoding complexity is relatively high. Therefore, how to ensure data storage reliability and reduce computing resource overhead is a technical problem that needs to be solved urgently.

Based on this, the embodiments of the present disclosure provide a data processing method, an apparatus, and a storage medium. The first processing node, after obtaining k source data blocks, encodes the k source data blocks through a first generator matrix to obtain n first encoded data blocks. Because the first generator matrix has a specific structure, encoding the k source data blocks through the first generator matrix can reduce the encoding computation amount without reducing storage reliability, thereby ensuring data storage reliability and reducing computing resource overhead.

Below, the solutions of the embodiments of the present disclosure are introduced with reference to the accompanying drawings.

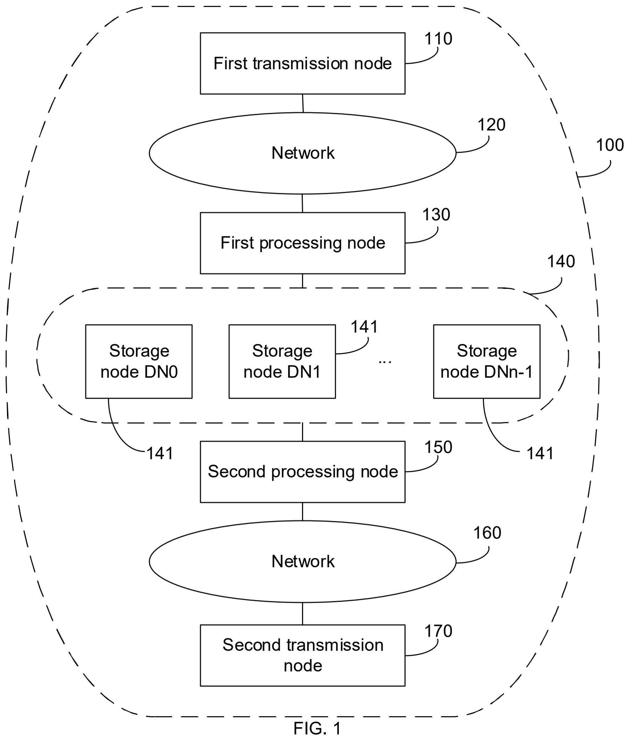

FIG. 1 is a structural schematic diagram of a communication system provided by the embodiments of the present disclosure. As shown in FIG. 1, the communication system 100 includes a first transmission node 110, a network 120, a first processing node 130, a storage node set 140, a second processing node 150, a network 160, and a second transmission node 170.

In some embodiments, the first transmission node 110 and the second transmission node 170 may be the same device or different devices. The first transmission node 110 and the second transmission node 170 may include but are not limited to: a server, a base station (base station, BS), a phone, a personal computer (personal computer, PC), a laptop computer, a tablet computer (tablet computer, TC), an access point (access point, AP), or other devices with functions of transmitting data and storing data.

In some embodiments, a relative location, a quantity, etc. of the first transmission node 110 and the second transmission node 170 may vary in specific application scenarios. For example, for the relative location: the first transmission node 110 may send data through a network, and the second transmission node 170 may receive data through a network. At the same time, the second transmission node 170 may send data through a network, and the first transmission node 110 may receive data through a network. Moreover, the first transmission node 110 and the second transmission node 170 may be in the same geographical spatial location or in different geographical spatial locations. For the quantity: the quantity of the first transmission node 110 and the second transmission node 170 may include one or more, and the first transmission node 110 and the second transmission node 170 are connected through a network.

In some embodiments, the network 120 and the network 160 may include but are not limited to: a wired network (Wired Network), a wireless network (Wireless Network), a cellular network (Cellular Network), a local area network (Local Area Network), the Internet (Internet), a wide area network (Wide Area Network), the Worldwide Web (Worldwide Web), or other networks for transmitting data.

In some embodiments, the first processing node 130 and the second processing node 150 may be the same processing node at different times in the same device. The first processing node 130 and the second processing node 150 may access and transfer data through a network, and process data according to configuration items. In an example, the configuration items include but are not limited to: a location of accessing a storage node, a location to transfer to a storage node, a quantity of redundant data blocks generated by encoding data blocks, a quantity of source data blocks, a size of source data blocks, a quantity of storage nodes, a quantity and location of failed storage nodes, a data recovery strategy, or other parameters for data processing.

In an example, data processing includes but is not limited to: encoding data blocks, allocating data blocks to storage nodes, accessing data blocks from data nodes, recovering failed data blocks, or other processing operations for reading, writing, deleting, or modifying data blocks.

In some embodiments, the execution subject of the data processing method in this embodiment may be but is not limited to the first processing node 120 or the second processing node 160 in the embodiment shown in FIG. 1. Alternatively, those skilled in the art may select and set a corresponding execution subject according to actual application scenarios. The embodiments of the present disclosure do not impose limitations, which, however, should not be understood as a limitation on the embodiments of the present disclosure.

In an embodiment, the storage node set 140 includes at least n storage nodes 141, for example, storage node DN0 to storage node DNn-1 as shown in FIG. 1. Each storage node 141 may include but is not limited to: a random access memory (random access memory, RAM), a read-only memory (read-only memory, ROM), an electrically erasable programmable read-only memory (electrically erasable programmable read-only memory, EEPROM), a flash memory or other memory technologies, or other optical disk storage, magnetic cartridges, magnetic tapes, disk storage, hard disks, solid state drives, or other storage devices, or any other media that can be used to store desired information and can be accessed by a computer.

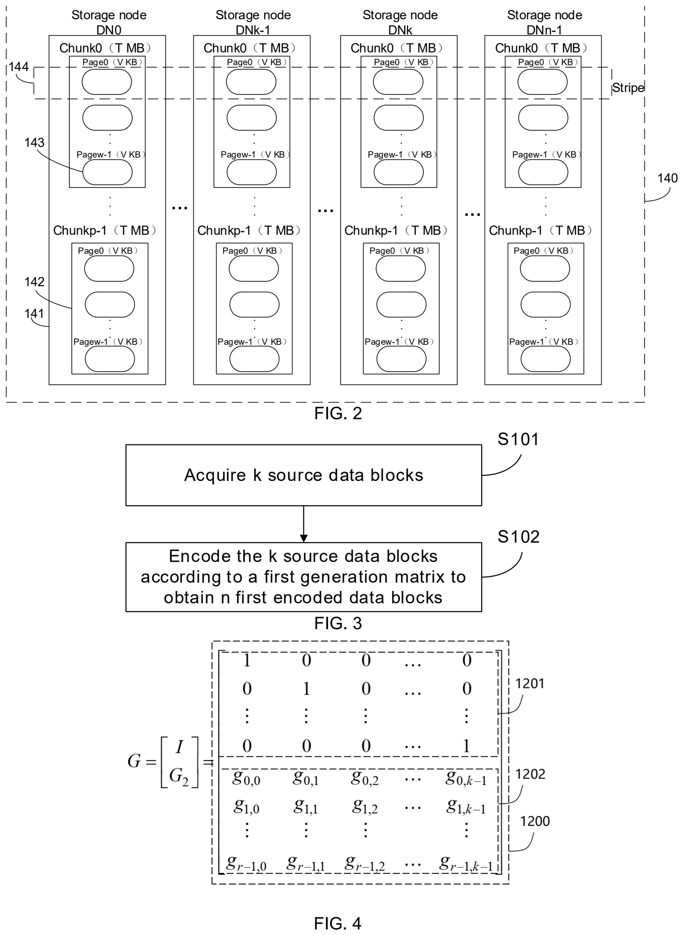

FIG. 2 is a composition schematic diagram of a storage node set provided by the embodiments of the present disclosure. As shown in FIG. 2, the storage node set 140 includes n storage nodes 141. A storage node 141 includes p chunk data blocks 142, and p is an integer greater than 0. Each chunk data block 142 includes w page data blocks 143, and w is an integer greater than 0. 144 represents a stripe, each stripe contains at most n page data blocks 143, and each page data block 143 is distributed in different storage nodes.

In some embodiments, the size of each chunk data block 142 is T megabytes (million bits per second, MB), T is an integer greater than 0, and T includes at least one of: 4, 8, 16, 32, 64, 128, 256, 512, 1024, 2048, 4096.

In some embodiments, the size of each page data block 143 is V kilobytes (Kbyte, KB), V is an integer greater than 0, and V includes at least one of: 4, 8, 16, 32, 64, 128.

In some embodiments, the first k data blocks $Page_0 \sim Page_{k-1}$ and the last r data blocks $Page_k \sim Page_{n-1}$ of each stripe 144 store source data blocks store check data blocks, where r = n - k.

It should be understood that FIG. 1 is an exemplary structure diagram, and a quantity of devices included in the communication system shown in FIG. 1 is not limited. Moreover, in addition to the devices shown in FIG. 1, the communication system shown in FIG. 1 may also include other devices, which is not limited herein.

As shown in FIG. 3, the embodiments of the present disclosure provide a data processing method. The method is applied to a first processing node. The first processing node may be the first processing node 130 shown in FIG. 1. The method includes at least steps S101 to S102.

In S101: k source data blocks are acquired.

Herein k is a positive integer.

In some embodiments, for each source data block $a_i$ in the k source data blocks, one source data block $a_i$ includes one or more chunk data blocks. The size of one source data block $a_i$ is T MB, $0 \leq i \leq k-1$, T is an integer greater than 0, and T includes at least one of: 4, 8, 16, 32, 64, 128, 256, 512, 1024, 2048, 4096.

As a possible example, T includes: 4, 8, 16, 32, and 64.

In some embodiments, each source data block $a_i$ contains one or more page data blocks. The size of one source data block $a_i$ is V KB, V is an integer greater than 0, and the value of V includes at least one of: 4, 8, 16, 32, 64, 128.

As a possible example, V includes: 4, 8, 16, and 32.

It can be understood that the source data blocks may be selected and set according to specific application scenarios, which is not limited in the embodiments of the present disclosure. The mode for acquiring source data blocks is well known to those skilled in the art, for example, acquiring from a file, which is not repeated herein.

In S102: the k source data blocks are encoded according to a first generator matrix to obtain n first encoded data blocks.

Herein a value range of an element of the first generator matrix is [0, q-1], and q is a prime number or a prime power.

In some embodiments, the first generator matrix G includes an identity matrix I and a second generator matrix $G_2$. The size of the identity matrix I is k×k, the size of the second generator matrix $G_2$ is r×k, and n=r+k, where r is a positive integer. k is a quantity of source data blocks. The n first encoded data blocks include k source data blocks and r second encoded data blocks. The r second encoded data blocks are data blocks obtained by encoding the k source data blocks according to the second generator matrix.

In some embodiments, the second encoded data blocks may also be referred to check data blocks.

Exemplarily, as shown in FIG. 4, FIG. 4 is a composition schematic diagram of a first generator matrix provided by the embodiments of the present disclosure. Referring to FIG. 4, the first generator matrix 1200 is composed of an identity matrix 1201 and a second generator matrix 1202. $g_{i,j}$ is an element value in the Galois field GF(q), and 0≤i≤r-1, 0≤j≤k-1. The size q of the Galois field is a prime number or a prime power, for example, q includes but is not limited to 2, 4, 8, 16, 32, 64, 128, 256, 512.

In some embodiments, for any k rows in the first generator matrix, any k rows are linearly independent in the Galois field GF(q). That is, any k rows of the first generator matrix form a submatrix of size k×k that is invertible in the Galois field GF(q).

It should be understood that any k rows in the first generator matrix are linearly independent in the Galois field GF(q), that is, the submatrix formed by any k rows of the first generator matrix is invertible, to ensure maximum distance separable (maximum distance separable, MDS). That is, to ensure that when any r first encoded data blocks in the n first encoded data blocks fail, the k source data blocks may be successfully decoded, thereby ensuring data storage reliability.

In some embodiments, there is a target row in the second generator matrix, and the values of elements in the target row are all 1. That is, there is a row in the second generator matrix where the element values are all 1.

In some embodiments, the check data block obtained by encoding the k source encoded data blocks according to the target row may be referred to a third encoded data block.

It should be understood that since approximately 95% of failures in storage systems are single storage node failures (or errors), the existence of a row with element values all being 1 in the second generator matrix is to quickly recover data lost due to a single storage node failure through XOR operation (which are faster than multiplication). Because the computation amount of the XOR operation is lower compared to multiplication, the computing resource overhead is reduced.

In some embodiments, for any r columns in a combined matrix composed of the second generator matrix and an identity matrix with a size of r×r, any r columns are linearly independent in the Galois field GF(q).

As an example, an identity matrix (size r×r) is added to the right side of the second generator matrix (size r×k) to form a combined matrix with a size of r×n.

In some embodiments, the combined matrix may also be referred to a check matrix.

It should be understood that the generator matrix and the check matrix can be understood as descriptions of the same encoding method from different perspectives. The features of the encoding method may be described through either the generator matrix or the check matrix. Storage erasure codes commonly use the generator matrix for encoding.

As a possible example, the value of the element with row number i and column number j in the second generator matrix is determined according to the following parameters: k, i, j; where i and j are non-negative integers, and 0≤i≤r-1, 0≤j≤k-1.

As another possible example, the value of the element with row number i and column number j in the second generator matrix is determined according to the following formula:

$$g_{i,j} = (k + j)/(k + i + j);$$

where $g_{i,j}$ represents the value of the element with row number i and column number j in the second generator matrix, i and j are non-negative integers, and 0≤i≤r-1, 0≤j≤k-1, / represents the division operation in the Galois field GF(q), and + represents the bitwise XOR operation in the Galois field GF(q).

As an example, the second generator matrix$G_2$may be as shown in the following formula:

$$G_2 = \begin{bmatrix} \dfrac{1}{k+0} & \dfrac{1}{k+1} & \dfrac{1}{k+2} & \cdots & \dfrac{1}{k+k-1} \\ \dfrac{1}{k+1+0} & \dfrac{1}{k+1+1} & \dfrac{1}{k+1+3} & \cdots & \dfrac{1}{k+1+k-1} \\ \vdots & \vdots & \vdots & \ddots & \vdots \\ \dfrac{k+0}{n-1+0} & \dfrac{k+1}{n-1+1} & \dfrac{k+2}{n-1+2} & \cdots & \dfrac{k+k-1}{n-1+k-1} \end{bmatrix};$$

Exemplarily, taking the size of the Galois field q=256, the source data blocks k=4, and the quantity of second encoded data blocks r=2 as an example, the second generator matrix $G_2$may be as follows:

$$G_2 = \begin{bmatrix} 1 & 1 & 1 & 1 \\ 166 & 70 & 187 & 123 \end{bmatrix};$$

In some embodiments, any two rows or two columns in the second generator matrix are commutative, that is, the second generator matrix may be obtained by exchanging any two rows or two columns in the second generator matrix.

As a possible example, the second generator matrix is obtained by exchanging any two rows or two columns of the matrix obtained according to the formula $g_{i,j} = (k + j)/(k + i + j)$. Herein, $g_{i,j}$ represents a value of an element with row number i and column number j in the matrix, i and j are non-negative integers, and $0 \le i \le r-1$, $0 \le j \le k-1$, /represents the division operation in the Galois field GF(q), and + represents the bitwise XOR operation in the Galois field GF(q).

Exemplarily, taking the size of the Galois field q=256, the source data blocks k=4, the quantity of second encoded data blocks r=2, and exchanging the first row and the second row of the matrix obtained according to the formula $g_{i,j} = (k + j)/(k + i + j)$ as an example. The second generator matrix $G_2$ may be as follows:

$$G_2 = \begin{bmatrix} 166 & 70 & 187 & 123 \\ 1 & 1 & 1 & 1 \end{bmatrix};$$

As another possible example, the value of the element with row number i and column number j in the second generator matrix is determined according to the following formula:

$$g_{i,j} = ((k + j) * (k + i))/((k + i + j) * k);$$

where $g_{i,j}$ represents the value of the element with row number *i* and column number *j* in the second generator matrix, / represents the division operation in the Galois field GF(q), + represents the bitwise XOR operation in the Galois field, and * represents the multiplication operation in the Galois field GF(q).

As an example, the second generator matrix $G_2$may be as shown in the following formula:

$$G_2 = \begin{bmatrix} 1 & 1 & 1 & \cdots & 1 \\ 1 & \dfrac{k+1}{k+1+1} \cdot \dfrac{k+1+0}{k+0} & \dfrac{k+2}{k+1+2} \cdot \dfrac{k+1+0}{k+0} & \cdots & \dfrac{k+k-1}{k+1+k-1} \cdot \dfrac{k+1+0}{k+0} \\ 1 & \dfrac{k+1}{k+2+1} \cdot \dfrac{k+2+0}{k+0} & \dfrac{k+2}{k+2+2} \cdot \dfrac{k+2+0}{k+0} & \cdots & \dfrac{k+k-1}{k+2+k-1} \cdot \dfrac{k+2+0}{k+0} \\ \vdots & \vdots & \vdots & \ddots & \vdots \\ 1 & \dfrac{k+1}{n-1+1} \cdot \dfrac{n-1+0}{k+0} & \dfrac{k+2}{n-1+2} \cdot \dfrac{n-1+0}{k+0} & \cdots & \dfrac{k+k-1}{n-1+k-1} \cdot \dfrac{n-1+0}{k+0} \end{bmatrix};$$

Exemplarily, taking the size of the Galois field q=256, the source data blocks k=4, and the quantity of second encoded data blocks r=2 as an example, the second generator matrix$G_2$may be as follows:

$$G_2 = \begin{bmatrix} 1 & 1 & 1 & 1 \\ 1 & 217 & 92 & 172 \end{bmatrix};$$

As a possible example, the second generator matrix is obtained by exchanging any two rows or two columns of the matrix obtained according to the formula $g_{i,j} = ((k + j) * (k + i))/CCk + i + j) * k)$. where $g_{i,j}$ represents a value of an element with row number i and column number j in the matrix, i and j are non-negative integers, and $0 \leq i \leq r-1$, $0 \leq j \leq k-1$, /represents the division operation in the Galois field GF(q), and + represents the bitwise XOR operation in the Galois field GF(q).

Exemplarily, taking the size of the Galois field q=256, the source data blocks k=4, the quantity of second encoded data blocks r=2, and exchanging the first column and the second column of the matrix obtained according to the formula $g_{i,j}$ = ((k+j) * (k + i))/((k + i + j) * k) as an example. The second generator matrix $G_2$ may be as follows:

$$G_2 = \begin{bmatrix} 1 & 1 & 1 & 1 \\ 217 & 1 & 92 & 172 \end{bmatrix};$$

In some embodiments, the n first encoded data blocks obtained by encoding the k source data blocks according to the second generator matrix are determined according to the following formula:

$$d = [a; G_2 * a];$$

where $d$ represents the n first encoded data blocks, $G_2$ represents the first generator matrix, * represents the matrix multiplication operation in the Galois field GF(q), and $a$ represents the k source data blocks $a = [a_0, a_1, ..., a_{k-1}]^T$. $d = [d_0, d_1, ..., d_{n-1}]^T = [a_0, a_1, ..., a_{k-1}, h_0, h_1, ..., h_{r-1}]^T$, $h_j$ represents the j-th second encoded data block in the r second encoded data blocks, j is a non-negative integer less than r, and T represents transpose.

In some embodiments, the n first encoded data blocks are determined according to the following formula:

$$d = G * a;$$

where $d$ represents the n first encoded data blocks, $G$ represents the first generator matrix, * represents the matrix multiplication operation in the Galois field GF(q), and $a$ represents the k source data blocks $a = [a_0, a_1, ..., a_{k-1}]^T$. Since the first k rows of the first generator matrix are an identity matrix, the first k first encoded data blocks of the n first encoded data blocks have the same value as the k source data blocks, $d = [d_0, d_1, ..., d_{n-1}]^T = [a_0, a_1, ..., a_{k-1}, h_0, h_1, ..., h_{r-1}]^T$. where T represents transpose, $[d_k, d_{k+1}, ..., d_{n-1}] = [h_0, h_1, ..., h_{r-1}]$, $h_j$ represents the j-th second encoded data block in the r second encoded data blocks, and j is a non-negative integer less than r. Exemplarily, taking the size of the Galois field q=256, the source data blocks k=4, the quantity of second encoded data blocks r=2, and each source data block containing 2 bytes as an example, the k source data blocks may be as shown in the following formula:

$$a = \begin{bmatrix} 245 & 245 \\ 247 & 124 \\ 41 & 205 \\ 248 & 37 \end{bmatrix};$$

In some embodiments, in the case where $g_{i,j} = (k + j)/(k + i + j)$, the n first encoded data blocks may be determined according to the following relationship:

$$d = G * a = \begin{bmatrix} 1 & 0 & 0 & 0 \\ 0 & 1 & 0 & 0 \\ 0 & 0 & 1 & 0 \\ 0 & 0 & 0 & 1 \\ 1 & 1 & 1 & 1 \\ 166 & 70 & 187 & 123 \end{bmatrix} * \begin{bmatrix} 245 & 245 \\ 247 & 124 \\ 41 & 205 \\ 248 & 37 \end{bmatrix} = \begin{bmatrix} 245 & 245 \\ 247 & 124 \\ 41 & 205 \\ 248 & 37 \\ 211 & 97 \\ 20 & 20 \end{bmatrix};$$

In some embodiments, in the case where $g_{i,j} = ((k + j) * (k + i))/CCk + i + j) * k)$, the n first encoded data blocks may be determined according to the following relationship:

$$d = G * a = \begin{bmatrix} 1 & 0 & 0 & 0 \\ 0 & 1 & 0 & 0 \\ 0 & 0 & 1 & 0 \\ 0 & 0 & 0 & 1 \\ 1 & 1 & 1 & 1 \\ 1 & 217 & 92 & 172 \end{bmatrix} * \begin{bmatrix} 245 & 245 \\ 247 & 124 \\ 41 & 205 \\ 248 & 37 \end{bmatrix} = \begin{bmatrix} 245 & 245 \\ 247 & 124 \\ 41 & 205 \\ 248 & 37 \\ 211 & 97 \\ 17 & 17 \end{bmatrix};$$

Based on the embodiment shown in FIG. 3, at least the following beneficial effects are brought: after obtaining k source data blocks, the k source data blocks are encoded based on the first generator matrix. Since any k rows in the first generator matrix are linearly independent in the Galois field GF(q), it is ensured that when any r first encoded data blocks in the n first encoded data blocks fail, the k source data blocks may be successfully decoded, thereby there is no need to reduce storage reliability. Moreover, there is a target row in the second generator matrix, so that faulty source data blocks may be recovered through simple XOR operations, reducing the computation amount, that is, reducing computing resource overhead, thereby ensuring data storage reliability and reducing computing resource overhead.

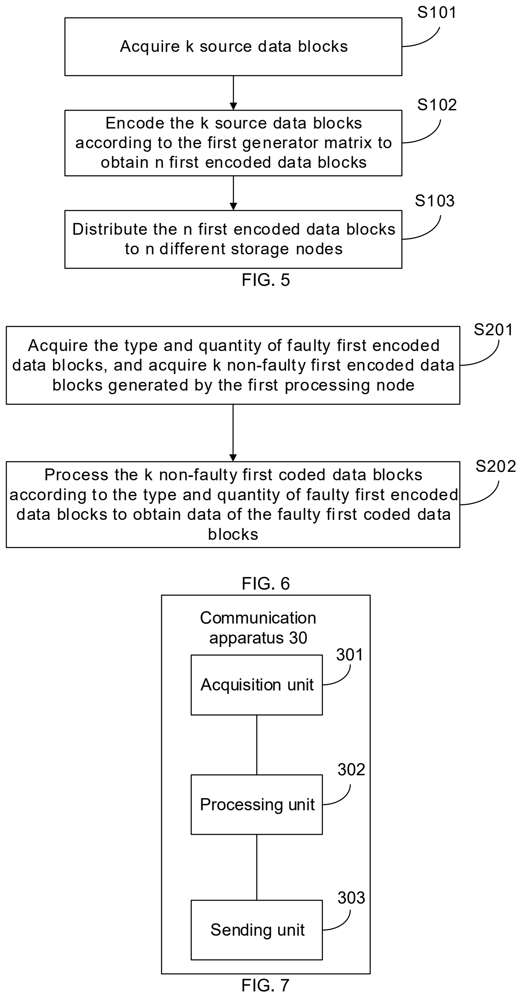

In some embodiments, as shown in FIG. 5, after step S102, the method further includes step S103.

In S103: the n first encoded data blocks are distributed to n different storage nodes.

In some embodiments, after obtaining the n first encoded data blocks, the n first encoded data blocks may be distributed to n different storage nodes to perform distributed storage of the n first encoded data blocks. The n different storage nodes may be the n storage nodes 141 included in the storage node set 140 shown in FIG. 1.

In some embodiments, the n first encoded data blocks are distributed to n different storage nodes according to at least one of: a contiguous allocation mode, an implicit link allocation mode, an explicit link allocation mode, an index allocation mode.

Herein, the contiguous allocation mode means that each first encoded data block occupies a set of contiguous data blocks on a storage node. The contiguous allocation mode supports sequential access and direct access, and the data block read/write speed is fast.

The implicit link allocation mode means that except for the last data block, each data block has a pointer pointing to the next data block. The implicit link allocation has high storage space utilization and facilitates data block expansion.

The explicit link allocation mode means that the pointers of respective data blocks for linking files are explicitly stored in a table. Each storage node establishes a data block allocation table to record the relationship between data blocks. The explicit link allocation has high storage space utilization and supports random access.

The index allocation mode means that an index table is established for each data block. The index table records the mapping relationship between logical blocks and physical blocks. The index allocation mode allows data blocks to be discretely allocated in different storage areas of storage nodes.

It should be noted that those skilled in the art may select and set a corresponding allocation mode according to actual application scenarios, which is not limited in the embodiments of the present disclosure.

It should be understood that the n first encoded data blocks are distributed to n different storage nodes, and when a storage node in n different storage nodes fails, only one first encoded data block of the n first encoded data blocks fails. If the n first encoded data blocks are distributed to m different storage nodes, where m is less than n, that is, a certain storage node stores more than one first encoded data block, then when that storage node fails, it may cause more than one first encoded data block to fail, reducing the reliability of stored data. Therefore, distributing the n first encoded data blocks to n different storage nodes can ensure data storage reliability.

In some embodiments, as shown in FIG. 6, the embodiments of the present disclosure provide a data processing method. The method is applied to a second processing node. The second processing node may be the second processing node 150 shown in FIG. 1 above. The method includes at least steps S201 to S202.

In S201: a type and quantity of faulty first encoded data blocks are acquired, and k non-failed first encoded data blocks generated by the first processing node are acquired.

Herein, the k non-failed first encoded data blocks are a subset of the n first encoded data blocks obtained by the first processing node encoding k source data blocks according to a first generator matrix. The first generator matrix includes an identity matrix and a second generator matrix. The size of the identity matrix is k×k, the size of the second generator matrix is r×k, and n=r+k, where r and k are positive integers. For related descriptions of the first generator matrix, reference may be made to the corresponding description in step S102 above, which will not repeated herein.

In some embodiments, the second processing node may obtain the k non-failed first encoded data blocks generated by the first processing node from storage nodes through a network.

In some embodiments, the type of faulty first encoded data blocks includes source data blocks or second encoded data blocks. The second encoded data blocks are data blocks obtained by encoding the k source data blocks according to the second generator matrix. The quantity of faulty first encoded data blocks is an integer greater than or equal to 0 and less than or equal to n.

In S202: the k non-failed first encoded data blocks are processed according to the type and quantity of the faulty first encoded data blocks to obtain data of the faulty first encoded data blocks.

Herein the data of the faulty first encoded data blocks includes faulty source data blocks and faulty second encoded data blocks.

It should be noted that in some cases, only the faulty source data blocks are what the second processing node wishes to obtain. Therefore, the obtained faulty first encoded data blocks may also only include the faulty source data blocks.

As a possible example, when the quantity of faulty first encoded data blocks is greater than r, it represents that the data of the first encoded data blocks is lost, and data recovery cannot be completed.

As another possible example, in a case where the quantity of faulty first encoded data blocks is equal to 0, it represents that the data of the first encoded data blocks is not lost, and there is no need to perform data recovery.

As another possible example, in a case where the faulty first encoded data blocks only include at most r second encoded data blocks, that is, in a case where the faulty first encoded data blocks only include at most r second encoded data blocks and 0 source data blocks, processing the k non-failed first encoded data blocks according to the type and quantity of the faulty first encoded data blocks to obtain the data of the faulty first encoded data blocks may be implemented as: obtaining the faulty second encoded data blocks according to the k source data blocks, the second generator matrix, and the index identifier(s) of the faulty second encoded data block(s).

Herein the index identifier(s) of the faulty second encoded data block(s) is/are used to uniquely indicate a faulty second encoded data block, for example, the index identifier(s) may be the location of the faulty second encoded data block in the n first encoded data blocks.

In some embodiments, for each first encoded data block in the encoded n first encoded data blocks, each first encoded data block has an index identifier. For example, the index identifier of the i-th first encoded data block in the n first encoded data blocks is i. For another example, the index identifier of the i-th first encoded data block in the n first encoded data blocks is i-1.

It should be understood that each first encoded data block has an index identifier, so that the receiving end may exactly know the location of each first encoded data block during encoding, in order to facilitate correct decoding.

As an example, assuming the index identifier of a faulty second encoded data block is *index0,* 0≤index0≤r-1, then the corresponding second encoded data block $h_{index0}$ of the faulty second encoded data block may be obtained according to the following formula:

$$h_{index0} = \left[g_{index0,0}, g_{index0,1}, \ldots, g_{index0,k-1}\right] * \left[a_0, a_1, \ldots, a_{k-1}\right]^T;$$

where *T* represents the transpose of the matrix, * represents the multiplication operation in the Galois field GF(q), g represents the value of the element in the Galois field GF(q), and $a_i$ represents the i-th source data block in the k source data blocks.

As another possible example, in a case where the faulty first encoded data blocks include 1 source data block and at most r-1 second encoded data blocks, and the faulty first encoded data blocks do not include a third encoded data block, processing the k non-failed first encoded data blocks according to the type and quantity of the faulty first encoded data blocks to obtain the data of the faulty first encoded data blocks may include at least steps A1 to A2.

In A1: 1 source data block is obtained according to k-1 source data blocks and a third encoded data block.

Herein, the third encoded data block is a data block obtained by encoding the k source data blocks according to the target row in the second generator matrix, and values of elements in the target row are all 1.

As an example, 1 source data block may be obtained according to the XOR operation of the k-1 source data blocks and the third encoded data block.

It should be understood that obtaining 1 source data block according to the XOR operation of the k-1 source data blocks and the third encoded data block can reduce the multiplication operation amount, thereby reducing the consumption of computing resources.

In A2: at most r-1 faulty second encoded data blocks are obtained according to the k source data blocks, the second generator matrix, and the index identifier(s) of the faulty second encoded data block(s).

As an example, assuming the index identifier of a faulty second encoded data block is *index1,* 0≤index1≤r-1, then the corresponding second encoded data block $h_{index1}$ of the faulty second encoded data block may be obtained according to the following formula:

$$h_{index1} = \left[g_{index1,0}, g_{index1,1}, \ldots, g_{index1,k-1}\right] * \left[a_0, a_1, \ldots, a_{k-1}\right]^T;$$

where *T* represents the transpose of the matrix, * represents the multiplication operation in the Galois field GF(q), g represents the value of the element in the Galois field GF(q), and $a_i$ represents the i-th source data block in the k source data blocks.

As another possible example, in a case where the faulty first encoded data blocks include at most r source data blocks, or in a case where the faulty first encoded data blocks include 1 source data block and at most r-1 first encoded data blocks that do not include a third encoded data block, processing the k non-failed first encoded data blocks according to the type and quantity of the faulty first encoded data blocks to obtain the data of the faulty first encoded data blocks may include at least steps B1 to B2.

In B1: v faulty source data blocks are determined according to at least one of the following parameters or the Gaussian elimination method.

Herein, the parameters include: the second generator matrix, k-v source data blocks, v second encoded data blocks, and the index identifier(s) of the k non-failed first encoded data block(s); v is used to represent the quantity of faulty source data blocks, and v is a positive integer.

In some embodiments, the Gaussian elimination method is an algorithm in linear algebra, which can be used to solve systems of linear equations, find the rank of a matrix, and find the inverse matrix of an invertible square matrix.

In B2: r-v faulty second encoded data blocks are determined according to the v faulty source data blocks, k-v non-failed source data blocks, the second generator matrix, and the index identifier(s) of the faulty second encoded data block(s).

Exemplarily, assuming the index identifier of a faulty second encoded data block is *index2*, 0≤index2≤r-1, the *index2*-th data block $h_{index2}$ in the at most r-v faulty second encoded data blocks is determined according to the following formula:

$$h_{index2} = G_2^{index2} * [a_0, a_1, ..., a_{k-1}]^T;$$

where $h_{index2}$ is obtained according to the second generator matrix and the index identifier *index2* of the faulty second encoded data block, and T represents transpose. As an example, $G_2^{index2}$ is the submatrix formed by the *index2*-th row of the second generator matrix $G_2$.

From the above embodiments, it can be seen that when the quantity of failed storage nodes does not exceed r, that is, when the quantity of faulty first encoded data blocks does not exceed r, the second processing node reads k first encoded data blocks to acquire (recover) the data in the failed storage nodes. Since any k rows in the first generator matrix are linearly independent, only any k first encoded data blocks need to be read to complete data recovery, without reading more than k first encoded data blocks. This can reduce the operation amount, thereby achieving the objective of ensuring data storage reliability and reducing computing resource overhead.

The above mainly describes the solution provided by the present disclosure from the perspective of interaction between various nodes. It can be understood that various nodes, for example, the first processing node or the second processing node, to achieve the above functions, include corresponding hardware structures and/or software modules for executing various functions. Those skilled in the art should easily realize that, in combination with the algorithm steps of various examples described in the embodiments disclosed in this document, the present disclosure can be implemented in hardware or a combination of hardware and computer software. Whether a function is executed by hardware or by computer software driving hardware depends on the specific application and design constraints of the technical solution. Professional technical personnel may use different methods for each specific application to implement the described function, but such implementation should not be considered beyond the scope of the present disclosure.

FIG. 7 shows a composition schematic diagram of a communication apparatus provided by the embodiments of the present disclosure. As shown in FIG. 7, the communication apparatus 30 includes an acquisition unit 301 and a processing unit 302. As a possible example, the communication apparatus 30 further includes a sending unit 303.

The communication apparatus 30 may be the aforementioned first processing node or a chip in the first processing node. When the communication apparatus 30 implement the function of the first processing node in the aforementioned embodiments, each unit of the communication apparatus 30 is specifically configured to implement the following functions.

The acquisition unit 301 is configured to acquire k source data blocks, where k is a positive integer.

The processing unit 302 is configured to encode the k source data blocks according to a first generator matrix to obtain n first encoded data blocks; where a value range of an element of the first generator matrix is [0, q-1], and q is a prime number or a prime power.

In some embodiments, the first generator matrix includes an identity matrix and a second generator matrix, the size of the identity matrix is k×k, the size of the second generator matrix is r×k, and n=r+k, where r is a positive integer; the n first encoded data blocks include k source data blocks and r second encoded data blocks. The r second encoded data blocks are data blocks obtained by encoding the k source data blocks according to the second generator matrix.

In some embodiments, for any k rows in the first generator matrix, the any k rows are linearly independent in the Galois field GF(q); where q is a prime number or a prime power.

In some embodiments, for any r columns in a combined matrix composed of the second generator matrix and an identity matrix with a size of r×r, the any r columns are linearly independent in the Galois field GF(q); where the size of the combined matrix is r×n, and q is a prime number or a prime power.

In some embodiments, there is a target row in the second generator matrix, and the values of elements in the target row are all 1.

In some embodiments, a value of an element with row number i and column number j in the second generator matrix is determined according to the following parameters: k, i, j; where i and j are both non-negative integers, and $0 \leq i \leq r-1$, $0 \leq j \leq k-1$.

In some embodiments, a value of an element with row number i and column number j in the second generator matrix is determined according to the following formula:

$$g_{i,j} = (k + j)/(k + i + j);$$

where $g_{i,j}$ represents the value of the element with row number i and column number j in the second generator matrix, i and j are both non-negative integers, and $0 \leq i \leq r-1$, $0 \leq j \leq k-1$, / represents a division operation in the Galois field GF(q), + represents a bitwise XOR operation in the Galois field GF(q), and q is a prime number or a prime power.

In some embodiments, a value of an element with row number i and column number j in the second generator matrix is determined according to the following formula:

$$g_{i,j} = ((k + j) * (k + i))/((k + i + j) * k);$$

where $g_{i,j}$ represents the value of the element with row number i and column number j in the second generator matrix, / represents a division operation in a Galois field GF(q), + represents a bitwise XOR operation in a Galois field, * represents a multiplication operation in a Galois field GF(q), and q is a prime number or a prime power.

In some embodiments, any two rows or two columns in the second generator matrix are commutative.

In some embodiments, the n first encoded data blocks are determined according to the following formula:

$$d = G * a;$$

where $d$ represents the n first encoded data blocks, $G$ represents the first generator matrix, * represents the matrix multiplication operation in the Galois field GF(q), and $a$ represents the k source data blocks.

In some embodiments, the sending unit 303 is configured to distribute the n first encoded data blocks to n different storage nodes according to at least one of: a contiguous allocation mode, an implicit link allocation mode, an explicit link allocation mode, an index allocation mode.

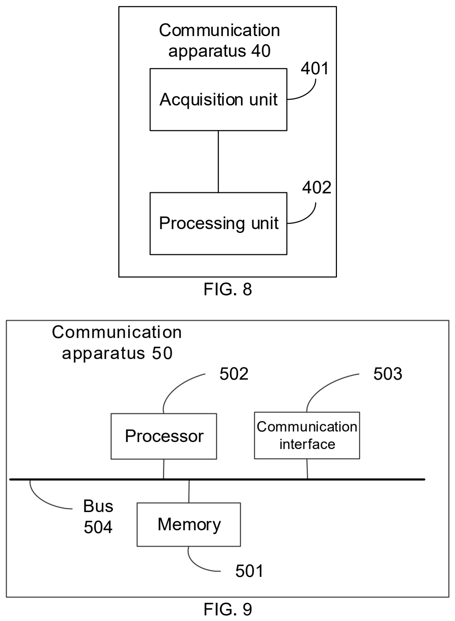

FIG. 8 shows a composition schematic diagram of another communication apparatus provided by the embodiments of the present disclosure. As shown in FIG. 8, the communication apparatus 40 includes an acquisition unit 401 and a processing unit 402.

The communication apparatus 40 may be the aforementioned second processing node or a chip in the second processing node. When the communication apparatus 40 implements the function of the second processing node in the aforementioned embodiments, each unit of the communication apparatus 40 is specifically configured to implement the following functions.

The acquisition unit 401 is configured to acquire a type and quantity of faulty first encoded data blocks, and acquire k non-faulty first encoded data blocks generated by a first processing node; where the k non-faulty first encoded data blocks are a subset of n first encoded data blocks obtained by the first processing node encoding k source data blocks according to a first generator matrix; the first generator matrix includes an identity matrix and a second generator matrix, a size of the identity matrix is k×k, a size of the second generator matrix is r×k, and n=r+k, where r and k are positive integers.

The processing unit 402 is configured to process the k non-faulty first encoded data blocks according to the type and quantity of the faulty first encoded data blocks to obtain data of the faulty first encoded data blocks; where the type of the faulty first encoded data blocks includes a source data block or a second encoded data block, the second encoded data block is a data block obtained by encoding the k source data blocks according to a second generator matrix, the quantity of the faulty first encoded data blocks is an integer greater than or equal to 0 and less than or equal to n, and the data of the faulty first encoded data blocks includes a faulty source data block and a faulty second encoded data block.

In some embodiments, in a case where the faulty first encoded data blocks only include at most r second encoded data blocks, the processing unit 402 is specifically configured to obtain the faulty second encoded data blocks according to the k source data blocks, the second generator matrix, and the index identifier(s) of the faulty second encoded data block(s).

In some embodiments, in a case where the faulty first encoded data blocks include one source data block and at most r-1 second encoded data blocks, and the faulty first encoded data blocks do not include a third encoded data block, the processing unit 402 is specifically configured to: obtain one source data block according to k-1 source data blocks and the third encoded data block; where the third encoded data block is a data block obtained by encoding the k source data blocks according to a target row in the second generator matrix, and the values of elements in the target row are all 1; obtain at most r-1 faulty second encoded data blocks according to the k source data blocks, the second generator matrix, and the index identifier(s) of the faulty second encoded data block(s).

In some embodiments, in a case where the faulty first encoded data blocks include at most r source data blocks, or the faulty first encoded data blocks include one source data block and at most r-1 first encoded data blocks that do not include the third encoded data block, the processing unit 402 is specifically configured to: determine v faulty source data blocks according to at least one of the following parameters or a Gaussian elimination method; the parameters include: the second generator matrix, k-v source data blocks, v second encoded data blocks, and the index identifier(s) of the k non-faulty first encoded data block(s); v is used to represent the quantity of faulty source data blocks, v is a positive integer, the third encoded data block is a data block obtained by encoding the k source data blocks according to a target row in the second generator matrix, and values of elements in the target row are all 1; determine r-v faulty second encoded data blocks according to the v faulty source data blocks, k-v non-faulty source data blocks, the second generator matrix, and the index identifier(s) of the faulty second encoded data block(s).

It should be noted that the units in FIG. 7 and FIG. 8 may also be referred to as modules, for example, the sending unit may be referred to as a sending module. Additionally, in the embodiments shown in FIG. 7 and FIG. 8, the names of each unit may not be the names shown in the FIG. 7 and FIG. 8, for example, the sending unit may also be referred to as a communication unit, and the acquisition unit may also be referred to as a communication unit.

If various units in FIG. 7 and FIG. 8 is implemented in the form of a software function module and sold or used as an independent product, the units may be stored in a computer-readable storage medium. Based on such understanding, the technical solution of the embodiments of the present disclosure, in essence, or the part contributing to the prior art, or all or part of the technical solution, may be embodied in the form of a software product, which is stored in a storage medium and includes several instructions to enable a computer device (which may be a personal computer, a server, or a network device, etc.) or a processor to execute all or part of the steps of the methods in the various embodiments of the present disclosure. The storage medium storing the computer software product includes: a U disk, a mobile hard disk, a read-only memory (ROM), a random access memory (RAM), a magnetic disk, or an optical disc, and other various media that can store program codes.

In a case where the aforementioned communication apparatus 30 or communication apparatus 40 implements the function of the aforementioned integrated modules in the form of hardware, the embodiments of the present disclosure provide a structural schematic diagram of a communication apparatus. As shown in FIG. 9, the communication apparatus 50 includes: a processor 502, a communication interface 503, and a bus 504. Optionally, the communication apparatus 50 may further include a memory 501.

The processor 502 may be configured to implement or execute various exemplary logic blocks, modules, and circuits described in connection with the disclosed contents of the present disclosure. The processor 502 may be a central processor, a general-purpose processor, a digital signal processor, an application specific integrated circuit, a field programmable gate array, or other programmable logic devices, transistor logic devices, hardware components, or any combination thereof. The processor 502 may implement or execute various exemplary logic blocks, modules, and circuits described in connection with the disclosed contents of the present disclosure. The processor 502 may also be a combination that implements computing functions, for example, including a combination of one or more microprocessors, a combination of a DSP and a microprocessor, etc.

The communication interface 503 is configured to connect with other devices through a communication network. The communication network may be an Ethernet, a wireless access network, a wireless local area network (WLAN), etc.

The memory 501 may be a read-only memory (ROM) or other types of static storage devices that may store static information and instructions, a random access memory (RAM) or other types of dynamic storage devices that may store information and instructions, or an electrically erasable programmable read-only memory (EEPROM), a magnetic disk storage medium or other magnetic storage devices, or any other media that can be used to carry or store desired program code having instructions or in the form of data structures and that can be accessed by a computer, which is however not limited thereto.

As a possible implementation, the memory 501 may exist independently of the processor 502, and the memory 501 may be connected to the processor 502 through the bus 504 for storing instructions or program code. When the processor 502 calls and executes the instructions or program code stored in the memory 501, the processor 502 can implement the data processing method provided by the embodiments of the present disclosure.

In another possible implementation, the memory 501 may also be integrated with the processor 502.

The bus 504 may be an extended industry standard architecture (EISA) bus, etc. The bus 504 may be categorized into an address bus, a data bus, a control bus, etc. For ease of representation, only one thick line is used to represent a bus in FIG. 9, but it does not mean that there is only one bus or one type of bus.

Through the description of the above implementation, those skilled in the art can clearly understand that for the convenience and brevity of description, only the division of the above functional modules is used as an example. In practical applications, the above functions may be allocated to different functional modules for completion as needed, that is, the internal structure of a base station or a terminal is divided into different functional modules to complete all or part of the functions described above.

The embodiments of the present disclosure further provide a computer-readable storage medium. All or part of processes in the above method embodiments may be completed by instructing the relevant hardware through computer instructions. The program may be stored in the above computer-readable storage medium. When the program is executed, the program may include the processes of the various method embodiments as described above. The computer-readable storage medium may be the memory of any of the foregoing embodiments. The above computer-readable storage medium may also be an external storage device of the above base station or terminal, for example, a plug-in hard disk equipped on the above base station or terminal, a smart media card (SMC), a secure digital (SD) card, a flash card, etc. Further, the above computer-readable storage medium may also include both the internal storage unit of the above base station or terminal and external storage devices. The above computer-readable storage medium is used to store the above computer program and other programs and data required by the above base station or terminal. The above computer-readable storage medium may also be used to temporarily store data that has been output or is to be output.

The embodiments of the present disclosure further provide a computer program product, the computer product contains a computer program, and when the computer program product is run on a computer, the computer is enabled to execute any one of the data processing methods provided in the above embodiments.

Although the present disclosure has been described herein in combination with various embodiments, in the process of implementing the claimed present disclosure, those skilled in the art may understand and realize other variations of the disclosed embodiments by viewing the accompanying drawings, the disclosure, and the appended claims. In the claims, the term "comprising" or variations thereof does not exclude other components or steps, and "a" or "an" does not exclude multiple. A single processor or other units may implement several functions listed in the claims. Some measures are recited in different dependent claims, but this does not mean that these measures cannot be combined to produce advantageous effects.

Although the present disclosure has been described in connection with specific features and embodiments thereof, it is obvious that various modifications and combinations can be made without departing from the spirit and scope of the present disclosure. Accordingly, the description and drawings are merely exemplary illustrations of the present disclosure as defined by the appended claims, and are considered to cover any and all modifications, variations, combinations, or equivalents within the scope of the present disclosure. Obviously, those skilled in the art can make various changes and modifications to the present disclosure without departing from the spirit and scope of the present disclosure. Thus, if these modifications and variations of the present disclosure fall within the scope of the claims of the present disclosure and equivalent technologies thereof, the present disclosure also intends to include these changes and variations.

The foregoing is merely specific implementations of the present disclosure, but the protection scope of the present disclosure is not limited thereto, and any changes or substitutions within the technical scope disclosed in the present application shall fall within the protection scope of the present disclosure. Therefore, the protection scope of the present disclosure shall be subject to the protection scope of the claims.

**Claims**

1. A data processing method, **characterized in that** the method is applied to a first processing node, and the method comprises:

   acquiring k source data blocks, wherein k is a positive integer;
   encoding the k source data blocks according to a first generator matrix to obtain n first encoded data blocks; wherein a value range of an element of the first generator matrix is [0, q-1], and q is a prime number or a prime power.

2. The method according to claim 1, wherein the first generator matrix comprises an identity matrix and a second generator matrix, a size of the identity matrix is k×k, a size of the second generator matrix is r×k, and n = r + k, wherein r is a positive integer;
   the n first encoded data blocks comprise k source data blocks and r second encoded data blocks, and the r second encoded data blocks are data blocks obtained by encoding the k source data blocks according to the second generator matrix.

3. The method according to claim 1, wherein for any k rows in the first generator matrix, the any k rows are linearly independent in a Galois field GF(q); wherein q is a prime number or a prime power.

4. The method according to claim 2, wherein for any r columns in a combined matrix composed of the second generator matrix and an identity matrix with a size of r×r, the any r columns are linearly independent in a Galois field GF(q); wherein a size of the combined matrix is r×n, and q is a prime number or a prime power.

5. The method according to claim 2, wherein there is a target row in the second generator matrix, and values of elements in the target row are all 1.

6. The method according to claim 2, wherein a value of an element with row number i and column number j in the second generator matrix is determined according to the following parameters: k, i, j; wherein i and j are non-negative integers, and $0 \leq i \leq r-1$, $0 \leq j \leq k-1$.

7. The method according to claim 6, wherein the value of the element with row number i and column number j in the second generator matrix is determined according to the following formula:

$$g_{i,j} = (k+j)/(k+i+j);$$

wherein $g_{i,j}$ represents a value of the element at row number $i$ and column number $j$ in the second generator matrix, $i$ and $j$ are non-negative integers, and $0 \leq i \leq r-1$, $0 \leq j \leq k-1$, / represents a division operation in a Galois field GF(q), + represents a bitwise XOR operation in a Galois field GF(q), and q is a prime number or a prime power.

8. The method according to claim 6, wherein the value of the element with row number i and column number j in the second generator matrix is determined according to the following formula:

$$g_{i,j} = ((k+j)*(k+i))/((k+i+j)*k);$$

wherein $g_{i,j}$ represents the value of the element with row number $i$ and column number $j$ in the second generator matrix, / represents a division operation in a Galois field GF(q), + represents a bitwise XOR operation in a Galois field, * represents a multiplication operation in a Galois field GF(q), and q is a prime number or a prime power.

9. The method according to claim 7 or 8, wherein any two rows or two columns in the second generator matrix are commutative.

10. The method according to claim 1, wherein the n first encoded data blocks are determined according to the following formula:

$$d = G * a;$$

wherein $d$ represents the n first encoded data blocks, $G$ represents the first generator matrix, * represents a matrix multiplication operation in a Galois field GF(q), and $a$ represents the k source data blocks.

11. The method according to any one of claims 1 to 10, wherein the method further comprises:
distributing the n first encoded data blocks to n different storage nodes according to at least one of:

   a contiguous allocation mode;
   an implicit link allocation mode;
   an explicit link allocation mode;
   an index allocation mode.

12. A data processing method, **characterized in that** the method is applied to a second processing node, and the method comprises:

   acquiring a type and a quantity of faulty first encoded data blocks, and acquiring k non-faulty first encoded data blocks generated by a first processing node; wherein the k non-failed first encoded data blocks are a subset of the n first encoded data blocks obtained by the first processing node encoding k source data blocks according to a first generator matrix, the first generator matrix comprises an identity matrix and a second generator matrix, a size of the identity matrix is k×k, a size of the second generator matrix is r×k, and n = r + k, wherein r and k both are positive integers;

processing the k non-faulty first encoded data blocks according to the type and the quantity of the faulty first encoded data blocks to obtain data of the faulty first encoded data blocks; wherein the type of the faulty first encoded data blocks comprise a source data block or a second encoded data block, the second encoded data block is a data block obtained by encoding the k source data blocks according to a second generator matrix, the quantity of the faulty first encoded data blocks is an integer greater than or equal to 0 and less than or equal to n, and the data of the faulty first encoded data blocks comprises a faulty source data block and a faulty second encoded data block.

13. The method according to claim 12, wherein in a case where the faulty first encoded data blocks only comprise at most r second encoded data blocks, the processing the k non-faulty first encoded data blocks according to the type and the quantity of the faulty first encoded data blocks to obtain the data of the faulty first encoded data blocks comprises: obtaining the faulty second encoded data blocks according to the k source data blocks, the second generator matrix, and index identifiers of the faulty second encoded data blocks.

14. The method according to claim 12, wherein in a case where the faulty first encoded data blocks comprise one source data block and at most r-1 second encoded data blocks, and the faulty first encoded data blocks do not comprise a third encoded data block, the processing the k non-faulty first encoded data blocks according to the type and the quantity of the faulty first encoded data blocks to obtain the data of the faulty first encoded data blocks comprises:

obtaining the one source data block according to k-1 source data blocks and the third encoded data block; wherein the third encoded data block is a data block obtained by encoding the k source data blocks according to a target row in the second generator matrix, and values of elements in the target row are all 1;
obtaining at most r-1 faulty second encoded data blocks according to the k source data blocks, the second generator matrix, and index identifiers of the faulty second encoded data blocks.

15. The method according to claim 12, wherein
in a case where that the faulty first encoded data blocks comprise at most r source data blocks, or the faulty first encoded data blocks comprise one source data block and at most r-1 first encoded data blocks that do not comprise a third encoded data block, the processing the k non-faulty first encoded data blocks according to the type and the quantity of the faulty first encoded data blocks to obtain the data of the faulty first encoded data blocks comprises:

determining v faulty source data blocks according to at least one of the following parameters or a Gaussian elimination method; the parameters comprises the second generator matrix, k-v source data blocks, v second encoded data blocks, and index identifiers of k non-faulty first encoded data blocks; v is used to represent a quantity of the faulty source data blocks, v is a positive integer, the third encoded data block is a data block obtained by encoding the k source data blocks according to the target row in the second generator matrix, and values of elements in the target row are all 1;
determining r-v faulty second encoded data blocks according to the v faulty source data blocks, k-v non-faulty source data blocks, the second generator matrix, and index identifiers of the faulty second encoded data blocks.

16. A communication apparatus, **characterized in that** the apparatus comprises: a processor and a memory;

the memory stores instructions executable by the processor;
the processor is configured to, upon executing the instructions, enable the communication apparatus to implement the method according to any one of claims 1 to 15.

17. A computer-readable storage medium, **characterized in that** the computer-readable storage medium comprises computer instructions, and upon that the computer instructions are run on a computer, the computer is enabled to execute the method according to any one of claims 1 to 15.

First transmission node — 110

Network — 120

100

First processing node — 130

140

Storage node DN0

Storage node DN1 — 141

...

Storage node DNn-1

141

Second processing node — 150

141

Network — 160

Second transmission node — 170

FIG. 1

Storage node DN0 | Storage node DNk-1 | Storage node DNk | Storage node DNn-1

Chunk0（T MB）

Page0（V KB）

Pagew-1（V KB）

Chunkp-1（T MB）

Page0（V KB）

Pagew-1（V KB）

Stripe

140

144  143  142  141

FIG. 2

S101

Acquire k source data blocks

S102

Encode the k source data blocks according to a first generation matrix to obtain n first encoded data blocks

FIG. 3

$$G = \begin{bmatrix} I \\ G_2 \end{bmatrix} = \begin{bmatrix} 1 & 0 & 0 & \cdots & 0 \\ 0 & 1 & 0 & \cdots & 0 \\ \vdots & \vdots & \vdots & & \vdots \\ 0 & 0 & 0 & \cdots & 1 \\ \hline g_{0,0} & g_{0,1} & g_{0,2} & \cdots & g_{0,k-1} \\ g_{1,0} & g_{1,1} & g_{1,2} & \cdots & g_{1,k-1} \\ \vdots & \vdots & \vdots & & \vdots \\ g_{r-1,0} & g_{r-1,1} & g_{r-1,2} & \cdots & g_{r-1,k-1} \end{bmatrix}$$

1201

1202

1200

FIG. 4

S101

Acquire k source data blocks

S102

Encode the k source data blocks according to the first generator matrix to obtain n first encoded data blocks

S103

Distribute the n first encoded data blocks to n different storage nodes

FIG. 5

S201

Acquire the type and quantity of faulty first encoded data blocks, and acquire k non-faulty first encoded data blocks generated by the first processing node

S202

Process the k non-faulty first coded data blocks according to the type and quantity of faulty first encoded data blocks to obtain data of the faulty first coded data blocks

FIG. 6

Communication apparatus 30

301

Acquisition unit

302

Processing unit

303

Sending unit

FIG. 7

Communication
apparatus 40

Acquisition unit — 401

Processing unit — 402

FIG. 8

Communication
apparatus 50

Processor — 502

Communication
interface — 503

Bus
504

Memory — 501

FIG. 9

## INTERNATIONAL SEARCH REPORT

| International application No. |
| --- |
| **PCT/CN2024/076006** |

| | |
| --- | --- |
| **A.** | **CLASSIFICATION OF SUBJECT MATTER** |

H03M13/37(2006.01)i; G06F11/10(2006.01)i; G06F3/06(2006.01)i

According to International Patent Classification (IPC) or to both national classification and IPC

| | |
| --- | --- |
| **B.** | **FIELDS SEARCHED** |

Minimum documentation searched (classification system followed by classification symbols)

    IPC: H03M G06F

Documentation searched other than minimum documentation to the extent that such documents are included in the fields searched

Electronic data base consulted during the international search (name of data base and, where practicable, search terms used)

    CNABS; CNTXT; CNKI; WPABS; DWPI; USTXT; WOTXT; EPTXT: 编码, 解码, 数据块, 矩阵, 故障, 异常, 损坏, 丢失, 恢复, 素数, 伽罗华, code, encode, decode, data block, matrix, failure, abnormity, malfunction, lose, recover, prime number, Galois

| | |
| --- | --- |
| **C.** | **DOCUMENTS CONSIDERED TO BE RELEVANT** |

| Category* | Citation of document, with indication, where appropriate, of the relevant passages | Relevant to claim No. |
| --- | --- | --- |
| X | CN 115113819 A (BOE TECHNOLOGY GROUP CO., LTD.) 27 September 2022 (2022-09-27) <br> description, paragraphs [0189]-[0432], and figures 1-8 | 1-6, 10-13, 16, 17 |
| A | CN 115113819 A (BOE TECHNOLOGY GROUP CO., LTD.) 27 September 2022 (2022-09-27) <br> description, paragraphs [0189]-[0432], and figures 1-8 | 7-9, 14, 15 |
| X | CN 115421975 A (ALIBABA (CHINA) CO., LTD.) 02 December 2022 (2022-12-02) <br> description, paragraphs [0034]-[0150], and figures 1-14 | 1-6, 10-13, 16, 17 |
| A | CN 114465627 A (SUZHOU INSPUR INTELLIGENT TECHNOLOGY CO., LTD.) 10 May 2022 (2022-05-10) <br> entire document | 1-17 |
| A | CN 114244376 A (SUZHOU INSPUR INTELLIGENT TECHNOLOGY CO., LTD.) 25 March 2022 (2022-03-25) <br> entire document | 1-17 |
| A | US 2004117718 A1 (MICROSOFT CORP.) 17 June 2004 (2004-06-17) <br> entire document | 1-17 |

☐ Further documents are listed in the continuation of Box C.    ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **20 March 2024** | **01 April 2024** |

| Name and mailing address of the ISA/CN | Authorized officer |
| --- | --- |
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

| Patent document cited in search report | | | Publication date (day/month/year) | Patent family member(s) | | | Publication date (day/month/year) |
|---|---|---|---|---|---|---|---|
| CN | 115113819 | A | 27 September 2022 | WO | 2024001494 | A1 | 04 January 2024 |
| CN | 115421975 | A | 02 December 2022 | | None | | |
| CN | 114465627 | A | 10 May 2022 | CN | 114465627 | B | 08 July 2022 |
| | | | | WO | 2023197506 | A1 | 19 October 2023 |
| CN | 114244376 | A | 25 March 2022 | CN | 114244376 | B | 13 May 2022 |
| US | 2004117718 | A1 | 17 June 2004 | US | 7581156 | B2 | 25 August 2009 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310672401